(19) Europäisches Patentamt
European Patent Office
Office européen des brevets

(11) **EP 1 290 458 B1**

(12) **EUROPÄISCHE PATENTSCHRIFT**

(45) Veröffentlichungstag und Bekanntmachung des Hinweises auf die Patenterteilung:
**24.05.2006 Patentblatt 2006/21**

(21) Anmeldenummer: **01951368.8**

(22) Anmeldetag: **13.06.2001**

(51) Int Cl.:
**G01R 31/11** *(2006.01)*

(86) Internationale Anmeldenummer:
**PCT/DE2001/002170**

(87) Internationale Veröffentlichungsnummer:
**WO 2001/096887 (20.12.2001 Gazette 2001/51)**

(54) **VERFAHREN ZUR FEHLERORTSMESSUNG BEI HOCHFREQUENZKABELN UND -LEITUNGEN**

METHOD FOR MEASURING FAULT LOCATIONS IN HIGH FREQUENCY CABLES AND LINES

PROCEDE DE MESURE POUR LA LOCALISATION DE DEFAUTS DANS DES CABLES ET DES LIGNES HAUTE FREQUENCE

(84) Benannte Vertragsstaaten:
**AT CH DE FR GB LI NL**

(30) Priorität: **16.06.2000 DE 10029000**
**29.05.2001 DE 10126262**

(43) Veröffentlichungstag der Anmeldung:
**12.03.2003 Patentblatt 2003/11**

(73) Patentinhaber: **T-Mobile Deutschland GmbH**
**53227 Bonn (DE)**

(72) Erfinder: **SCHMIDT, Rolf**
**34212 Melsungen (DE)**

(74) Vertreter: **Riebling, Peter**
**Patentanwalt**
**Postfach 31 60**
**88113 Lindau (DE)**

(56) Entgegenhaltungen:
**WO-A-00/29862          GB-A- 2 239 956**
**US-A- 4 630 228          US-A- 5 661 404**
**US-A- 5 949 236**

• **PATENT ABSTRACTS OF JAPAN vol. 1999, no. 13, 30. November 1999 (1999-11-30) & JP 11 211766 A (ADVANTEST CORP), 6. August 1999 (1999-08-06)**

**Beschreibung**

Die Erfindung betrifft ein Verfahren zur Fehlerortmessung bei Hochfrequenzkabeln und -leitungen nach dem Oberbegriff des Patentanspruchs 1.

Eine Fehlerortmessung wird verwendet, um Kabellängen zu messen oder Fehlerstellen in Kabeln zu finden. In der Regel wird dazu ein kurzer Impuls in das zu messende Kabel gesendet und dann die Laufzeit, der Pegel und die Phase der Reflexionen des Impulses gemessen und bewertet. Eine solche Messung wird auch als TDR-Messung bezeichnet. Hierzu sind jedoch recht aufwendige Vektor-Network-Analyser-Systeme notwendig, die in den Ausmaßen recht unhandlich, schwer und daher eher Laborgeräte sind.

Als Alternative bietet sich jedoch noch eine weitere Variante an, die technisch weniger aufwendig ist, jedoch einiges an Rechenleistung benötigt. Bei dieser Variante wird ein Frequenz-Sweep in das Kabel gesendet und die Addition des Grundsignals und des reflektierten Signals in aufwendigen Rechnungen bewertet, sodass eine Fehlerortbestimmung möglich ist. Diese Variante wird auch als FDR-Messung bezeichnet. Bei der FDR-Messung macht man sich den Umstand zu nutze, dass eine Frequenzinformation mittels einer Fouriertransformation (oder Fast-Fourier-Transformation) in den Zeitbereich umgewandelt werden kann.

Ein Spektrumanalyser mit integrierten Frequenzgenerator ist inzwischen zu einem kleinen robusten Gerät geworden, welches sich gerade im mobilen Einsatz bewährt und genau für einen solchen Anwendungsfall geeignet ist.

Die US-A-5 949 236 offenbart ein Verfahren zur Fehlerortmessung bei Hochfrequenzkabeln und -leitungen unter Verwendung eines Frequency Domain Reflektometers. Auf die Messsignale wird ein Dämpfungskorrekturfaktor angewendet, um Kabeldämpfungen des Messkabels zu korrigieren. Der Dämpfungskorrekturfaktor wird anhand eines Messdurchlaufs mit einer Referenzimpedanz ermittelt. Eine Verwendung eines Spektrumanalysators für die Fehlerortmessung ist nicht offenbart.

Die WO-A-00 29862 lehrt ein Verfahren zur Korrektur der frequenz- und längenabhängigen Leitungsdämpfungen bei FDR-Messungen an Hochfrequenzkabeln, bei dem eine für eine bestimmte Kabellänge anzuwendende Korrekturfunktion zur Korrektur des ermittelten Dämpfungsverlaufs anhand vom Hersteller vorgegebenen Dämpfungswerten ermittelt wird.

Aufgabe der Erfindung ist es, ein Verfahren zu beschreiben, mit den Daten aus einem Spektrumanalysator eine Fehlerort-Messung nach FDR durchzuführen, dabei ein besonderes Augenmerk auf die Kalibrierungsdaten und deren Anwendung zu richten.

Diese Aufgabe wird durch die Merkmale des Patentanspruchs 1 gelöst.

In welcher Form die Rechenschritte des Verfahrens durchgeführt, wie die Daten dem Verfahren zugeführt und wie die Ergebnisse des Verfahrens dargestellt werden ist dabei unerheblich. Während der Entwicklung des Verfahrens wurde vornehmlich mit EXCEL (Software der Fa. Microsoft) gearbeitet, es ist aber auch denkbar das Verfahren als eigene Software, die dann auch die Steuerung des Analysators vornehmen kann, auszuführen oder direkt in den Analysator zu implementieren.

Vorteilhafte Ausführungsformen und Weiterbildungen des erfindungsgemäßen Verfahrens sind in den abhängigen Patentansprüchen angegeben.

Die Erfindung wird nachfolgend anhand eines Ausführungsbeispiels mit

Bezugnahme auf die Zeichnungen näher erläutert. Aus den Zeichnungen und ihrer Beschreibung ergeben sich weitere Merkmale, Vorteile und Anwendungsgebiete der Erfindung.

Figur 1      zeigt schematisch einen möglichen Aufbau der Messapparatur zur Durchführung des Verfahrens;

Figur 2:     Darstellung eines Messdiagramms einer Messung an einer Leitung bestehend aus drei miteinander verbunden Kabeln mit jeweils 15 m Länge und Fehlabschluss mit s=1,2 am Ende der Leitung;

Figur 3:     Darstellung eines Messdiagramms einer Messung an einer Leitung bestehend aus drei miteinander verbunden Kabeln mit jeweils 15 m Länge und offenem Kabelende.

Es gelten alle Regeln der Fast-Fouriertransformation, der Komplexen-Rechnung und die Grundlagen der numerischen Mathematik.

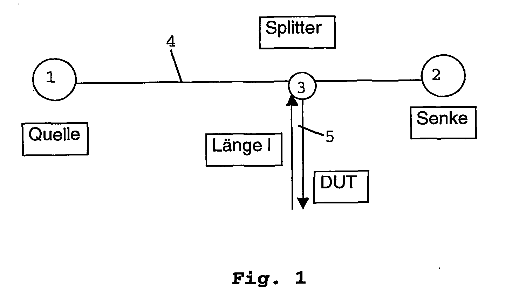

Der Aufbau der verwendeten Messapparatur ist schematisch in Figur 1 dargestellt. Ausgegangen wird von einer Quelle (dem Signalgenerator), der eine beliebige einstellbare Frequenz erzeugen kann, einem Powersplitter als Koppelglied welches in jede Richtung eine Anpassung mit 50Ohm realisiert und einer Senke (Spannungsmesser), der die Spannungen eines Signals mit der Frequenz f messen kann.

Von der Signalquelle 1 wird ein Signal mit der Frequenz f0 und einem Pegel a0 in ein Messkabel 4 ausgesendet. Dieses Signal wird im Splitter 3 aufgeteilt und zu gleichen Teilen in den Prüfling 5 (DUT= Device under Test) und zur Senke 2 weitergeleitet. Wenn man annimmt, dass am Ende des DUT 5 eine Totalreflexion vorliegt, wird sich auf dem DUT eine stehende Welle ausbilden. Nimmt man nun weiterhin an, dass sich der Powersplitter 3 auf einen Punkt konzentriert, werden die Signale der Quelle 1 und die rücklaufende Welle des DUT 5 in genau diesem Punkt addiert.

Ergebnis dieser Addition ist ein Signal mit der Frequenz f0 und einer Amplitude a1, die eine Funktion der Addition ist und von der Art der Reflexion (kapazitiv / induktiv), der Länge l des DUT und dem Reflexionsfaktor abhängt. Dieses Signal kann an der Senke 2 gemessen werden.

Das bis jetzt gewonnene Ergebnis ist jedoch noch nicht ausreichend, um eine Aussage über den Fehlerort zutreffen. Wenn nun die Frequenz f0 in ihrem Wert geändert wird und man wiederum die Amplitude des neu erzeugten Summensignals aufnimmt und dies wiederholt in einem geeigneten Bereich (Span) durchführt, wird man erkennen können, dass die Amplitudenmesswerte des Summensignals einer Sinusschwingung stark ähneln, wobei es sich hierbei natürlich um eine Sinusschwingung im Frequenzbereich d.h. der Frequenzmesswerte handelt.

An diesem Punkt angelangt wird auf genau diese Messwerte eine Fouriertransformation angewendet, die den Zeitbereich in den Frequenzbereich wandelt und umgekehrt. Es ist zu erwarten, dass die Transformation (analog zur Wandlung einer Sinusschwingung vom Zeit in den Frequenzbereich) einen ausgeprägten Peak im Zeitbereich erzeugt.

Wie erwartet tritt das Ergebnis auch ein, wobei der Peak die Zeit darstellt, die eine Welle benötigt, um vom Splitter 3 zum Reflexionspunkt und wieder zurück zu laufen.

Die Stoßstelle kann somit, unter Berücksichtigung des Verkürzungsfaktors, in ihrer Örtlichkeit gefunden werden. Der Amplitudenwert des Peaks lässt darüber hinaus eine Aussage über den Reflexionsfaktor zu, ist der Peak sehr hoch, handelt es auch um eine starke Reflexion.

Hiermit ist nun die Grundlage gelegt, um mit dem beschriebenen Verfahren eine Fehlerortbestimmung durchzuführen.

Konfiguration des Spektrumanalysators:

Zur Durchführung des Verfahrens wird ein Spektrumanalysator verwendet. Der Analysator muss über einen Tracking-Generator verfügen und sollte in der Auflösung (Punkte pro Sweep) einstellbar sein. Als externe Komponenten wird lediglich noch ein Power-Splitter (Dämpfung in jede Richtung von 6dB) benötigt, der den Ausgang des Tracking-Generators mit dem Eingang des Analysators und dem DUT verbindet.

Die Mittenfrequenz ist so einzustellen, dass die Nutzfrequenz des DUT für die Messung genutzt wird und den Span-Bereich zulässt, der für die zu messende Kabellänge und Auflösung ausschlaggebend ist.

Nachfolgend sollen die wesentlichen Einstellungen des Analysators aufgelistet werden:

| | | | |
|---|---|---|---|
| Messpunkt: | | | |
| Anzahl: | Ein vielfaches von 2^x, also 2, 4, 8, 16, ....; 256, 512, 1024 usw. | | |
| | Ein guter Kompromiss ist 512. | | |
| | Ist der Wert nicht einstellbar, ist nur eine Anzahl 2^x Punkte | | |
| | (wegen der FFT) nutzbar! | | |
| Y-Amplituden Einstellung: | | | |
| Skalierung: | Linear | | |
| Ref-Level: | 200mV | | |
| Frequenz Einstellung: | | | |
| Mittenfrequenz: | Nutzfrequenz des zum messenden DUT | | |
| Span: | Abhängig von der zu messenden Länge und der Anzahl der Messpunkte (siehe auch unten) | | |
| Span.Beispiele: | 700Mhz | kleiner 25m | bei 512 Messpunkten |
| | 300Mhz | kleiner 60m | bei 512 Messpunkten |
| | 100Mhz | kleiner 190m | bei 512 Messpunkten |
| Tracking-Generator: | | | |
| Power-Level: | 200mV | | |
| Averaging: | | | |
| Video-Averaging: | 10 | | |

Alle anderen Parameter, wie Messbandbreite, Sweeptime usw. sollten nach den automatischen Vorgaben des Analysators eingestellt werden, da so das Optimum aus dem Analysator herausgeholt werden kann.

Durchführung der Messung:

Nachdem der Analysator eingestellt und die Verkabelung vorgenommen wurde, kann mit der Messung begonnen werden.

Hierzu sollte zwischen DUT und Powersplitter ein Messkabel (Vorlaufkabel) geschaltet werden, welches, wie der Powersplitter und das Messsystem selbst, herauskalibriert wird. Es ist jedoch darauf zu achten, dass die angeschalteten Komponenten (Splitter, Vorlaufkabel, Verbindungskabel, Übergänge) in gutem Zustand sind und dem Z-Wert des Systems entsprechen.

Die Messung besteht aus zwei Kalibriermessungen, denen dann eine beliebige Anzahl von Objekt-Messungen folgen kann.

Eine Kalibriermessung ist ein SHORT am Ende des Vorlaufkabels.

Die zweite Kalibriermessung ist ein LAOD am Ende des Vorlaufkabels.

Verfahren zur FDR:

Vorbereitung und Wandlung vom Frequenzbereich in den Zeitbereich:

Ausgangspunkt für die folgende mathematisch Stossstellenbestimmung sind die drei Messreihen

**as()** [Short],
**al()** [Load] und
**ad()** [DUT]

mit einer Arraygröße von je $2^x$ Messpunkten.

Diese drei Messreihen können auch in komplexer Schreibweise dargestellt werden **{z:=a+bi},** wobei der Imaginärteil der Messereihen immer mit 0 angenommen wird:

$$zs() := as() + 0i$$

$$zl() := al() + 0i$$

$$zd() := ad() + 0i$$

Die folgenden Betrachtungen gehen davon aus, das ein Array mit dem Index 0 beginnt.

Um die Auflösung im Bereich starker Stoßstellen zu vergrößern, bietet es sich an, die Messreihen einem WINDOWING zu unterziehen. Ein einfaches Window (Fenster) ist ein Cosinus-Roll-Off Fenster, also eine Kosinusfunktion, die invertiert, mit dem Wert eins addiert, dann halbiert wurde und den Bereich 0 bis 2*PI für die Messpunkte 0 bis ($2^x$ - 1) abdeckt.

$$Window(index) = 0.5*(1-COS(index*2*PI/(2^x-1)))\ für\ Index\ [0\ bis\ 2^x-1]$$

Jeder Messpunkt der Arrays wird nun mit dem äquivalenten Messpunkt des Cosinus-Fensters multipliziert und wieder in das Array zurückgeschrieben.

Es sind natürlich auch alle andere Fensterfunktionen möglich.

Im folgenden wird davon ausgegangen, dass die Messwerte, gefenstert oder nicht, in den Arrays **zs(), zl()** und **zd()** vorliegen.

Auf jede dieser komplexen Messreihen wird nun die inverse Fast-FourierTransformation (iFFT) ausgeführt, die als Ergebnis ein komplexes Array mit $2^x$ Punkten (für jede Messreihe) erzeugt.

$$zts() := iFFT\ [zs()]$$

$$ztl() := iFFT\ [zl()]$$

$$ztd() := iFFT\ [zd()]$$

Das erste Element des Arrays repräsentiert den Gleichspannungsanteil der Messreihe und wird für alle weiteren Betrachtungen ausgeschlossen.

Eine FFT liefert zwar $2^x$ Punkte als Ergebnis, es handelt sich dabei jedoch um eine Ergebnisreihe, mit $2^{(x-1)}$ Punkten, die gespiegelt ist.

Für alle weitern Betrachtungen genügt es somit, wenn man das Array bis zum Index $(2^{(x-1)})-1$ betrachtet.

Aus diesem Grund, werden nun die Arrays **zts(), ztl()** und **ztd()** auf die Indizes $(1 ... (2^{(x-1)})-1)$ beschränkt.

Normierung auf SHORT

Von den Ergebnissen in der Reihe **zts()** ist bekannt, dass es sich um einen Kurzschluss am Ende des Vorlaufkabels handelt. Es ist also zu erwarten, das im Zeitbereich ein ausgeprägter Maximalwert zu finden ist, der genau das Ende dieses Vorlaufkabels und somit den SHORT repräsentiert.

Im Array $(2 ... (2^{(x-1)})-1)$ [es wird beim Index 2 begonnen, da nach einem Windowing der Peak in der Breite zunimmt, was auch für den Gleichspannungsanteil zutrifft] wird nun nach diesem Maximalwert gesucht und wenn er gefunden wurde, sowohl der Wert als auch der Index extrahiert. Der Index, an dem das Maximum gefunden wurde, wird im folgenden (**max**) genannt, sodass der Wert dieses Punktes mit **zts(max)** bezeichnet werden kann.

Der komplexe Wert **zts(max)** wird nun in den Absolut-Wert [Betrag] (**abs{}**) und sein Argument [Phase] (**arg{}**) umgewandelt.

Hierbei gelten die Regeln der komplexen Rechnung:

Bei **z := a + bi** folgt

$$\mathbf{abs\{z\} = sqr\ (a\char`^2 + b\char`^2)}$$

und

$$\mathbf{arg\{z\} = arctan(b/a)}$$

Da es sich bei diesem Messwert um einen SHORT handelt, kann man mit folgender Annahme arbeiten:

Ein Short ist eine Reflexion mit dem Wert 1 und mit einem Phasenversatz von 180° (Pi).

Für die Werte **abs{zts(max)}** und **arg{zts(max)}** sind hierfür nun geeignete Faktoren und Summanden zu finden, die wie folgt bezeichnet werden:

$$\mathbf{korabs = 1/(abs\{zts(max)\})}$$

$$\mathbf{korarg = PI + arg\{zts(max)\}}$$

Ziel ist es nun, die Messwerte aller Messreihen mit diesen Faktoren zu korrigieren und damit bezogen auf einen SHORT am Ende des Vorlaufkabels definierte Zustände zu erhalten.

Hierzu ist zunächst die Umwandlung in Absolutwert und Argument für jedes Element der Messreihen durchzuführen.

Daraufhin folgt die Normierung nach der Form:

$$\mathbf{abs\{zt\_k()\} := korabs * abs\{zt\_()\}}$$

$$\mathbf{arg\{zt\_k()\} := korarg - arg\{zt\_()\}}$$

Der Unterstrich steht hierbei für **s** (Short), **l** (Load) und **d** (DUT).

Aus den entsprechenden Arrays für Absolutwert und Argument, werden im folgenden wieder komplexe Arrays erzeugt, wobei folgender Zusammenhang gilt:

$$zt\_k() := [abs\{zt\_k()\} * \cos(\arg\{zt\_k()\})] + [abs\{zt\_k()\} * \sin(\arg\{zt\_k()\})]i$$

Die erste Normierung ist hiermit durchgeführt.

Die erzeugten Absolutwerte entsprechen nun der Einheit UNITS, ein in Kreisen von Networkanalysatoren gebräuchlicher Wert, der eine Aussage über die Anpassung macht und eine Umrechnung in dB auf folgende Weise erlaubt:

$$Anpassung[dB] = 20*\log(UNITS) \qquad -> 1Unit = 0dB, 0.01Unit = -40dB$$

Normierung auf LOAD

Bis zum jetzigen Zeitpunkt, sind lediglich die Phasen und Beträge der Messungen angepasst, also normiert worden. Geht man davon aus, dass es sich bei dem Messsystem um ein ideales System handelt, sprich dass in diesem System immer optimale Anpassung herrscht und somit keine Reflexionen erzeugt werden, ist sicherlich keine weitere Normierung notwendig.

In realen System ist dies jedoch nicht der Fall, sodass interne Reflexionen einige Probleme bereiten und schnell zu Fehlmessungen führen können, wenn diese nicht eliminiert werden.

Nun kann man nicht die Reflexionen beseitigen, man kann aber eine mathematische Rückrechnung machen, die diese Fehler des Messsystems ermittelt und dann in der Messung korrigiert.

Im folgenden wird nun diese Korrektur näher beschrieben.

Von den Ergebnissen in der Reihe **ztlk()** ist bekannt, dass es sich um einen Load am Ende des Vorlaufkabels handelt. Alle Werte im Zeitbereich sollten bei dieser Messung also als ideale Messung gelten, also keine Reflexionen und Stoßstellen aufweisen. In einem realen System kann man aber sehr wohl solche Fehlerstellen erkennen, die aber lediglich die Fehler des eigentlichen Messsystems darstellen. Solche Fehler haben in der späteren Messung jedoch keine Aussagekraft und müssen deshalb dort eliminiert werden. Dies geschieht dadurch, dass von den Messwerten **ztdk()** die Messwerte **ztlk()** in komplexer Weise abgezogen (Subtrahiert) werden.

Es entsteht eine neue Messreihe, die folgender Beziehung gehorcht:

$$ztdkk() := ztdk() - ztlk() \text{ [Komplexe Subtraktion]}$$

Es ist außerordentlich wichtig diese Subtraktion in komplexer Weise auszuführen, da nur so gewährleistet ist, dass nur die Systemfehler eliminiert werden und Fehlerstellen im Objekt weiterhin erkennbar bleiben, da die Phaseninformation als zusätzlicher Indikator zur Verfügung steht.

In dem Array **ztdkk()** sind nun die amplituden- und fehlerkorrigierten Messwerte des Messobjekts enthalten.

Einfügen von Kabeldaten

Bis zum jetzigen Zeitpunkt waren alle kabelspezifischen Daten wie Dämpfung und Verkürzungsfaktor unrelevant. Für den nächsten Schritt sind diese Werte jedoch von großer Bedeutung.

Zunächst wird mittels des Verkürzungsfaktors die Schrittweite pro Messpunkt ermittelt.

Hierfür wird folgende Formel verwendet:

$$St := ((Vc * c)/Sp)/2$$

**Vc** := VelocityFaktor (Verkürzungsfaktor [0 .. 1])
**c** := Lichtgeschwindigkeit mit ca. 299.792.458 m/sec (im Vakuum)
**Sp** := Spanbereich in Mhz (Messspan)
**St** := Step in der Einheit Meter

**Dämpf**:= Kabeldämpfung in der Einheit dB/m

Hieraus kann man nun mit der Formel

$$MaxDist := (AnzahlMesspunkte / 2) * St$$

die maximale Distanz, die angezeigt werden kann, errechnet werden.

Die Anzahl der Messpunkte muss hierfür halbiert werden, da die iFFT am Mittelpunkt des Arrays ein gespiegelt ist.

Es ist jedoch sehr problematisch diesen gesamten Wertebereich auszunutzen, da es ebenfalls ein Wesen der iFFT ist, dass starke Peaks als Harmonische im Verlauf der Messreihe wieder auftreten können. Dies ist dann recht problematisch, wenn am Ende des Messobjektes eine große Stoßstelle vorhanden ist, die in abgeschwächter Form in der doppelten Messentfernung durch die iFFT wieder auftritt (ca. 30dB schwächer) und so durch das oben erwähnte Spiegelverhalten der iFFT zurück in den Messbereich gespiegelt wird. Hier ist dann eine Fehlinterpretation der Messung die unweigerliche Folge.

Aus diesem Grund ist es erforderlich, den nutzbaren Messbereich nochmals um die Hälfte zu reduzieren und so diese Spiegelbilder aus den Betrachtungsraum der Messwerte weitestgehend zu eliminieren.

$$NutzDist := (AnzahlMesspunkte / 4) * St \text{ [siehe oben]}$$

Mit Hilfe der vorrangegangen Informationen ist es nun möglich, die Daten aufzubereiten und darzustellen. Jedem Messpunkt kann mit der Formel

$$Dist := Index * St$$

eine eindeutige Entfernung zugeordnet werden, was in der grafischen Darstellung hilfreich ist. Zudem soll es das Ziel sein, nur die Messwerte ab dem Index (**max**) darzustellen, da alle Messwerte davor lediglich das Vorlaufkabel und das Messsystem darstellen. Weiterhin muss der Dämpfungsverlauf des Kabels ab dem Punkt des Index (**max**) herausgerechnet werden, um korrekte Anpassungswerte auch in größeren Entfernungen sicher bestimmen zu können.

Es wird ein Array **Dist()** angelegt, welches (**NutzDist**) Werte enthält.

Ausgehend von dem Array **Dist()** wird nun ein Array **AmpKor()** nach folgender Formel erzeugt:

$$AmpKor() := 10^{\wedge}((2 * Dist() * Dämpf)/20)$$

wobei der Wert **Dämpf** die Dämpfung des Kabels in dB auf einen Meter angibt

Der Faktor 2, mit dem **Dist()** multipliziert wird ist notwendig, da die Welle das Kabel einmal als hinlaufende und einmal als rücklaufende passiert und die Kabeldämpfung damit zweimal zu berücksichtigen ist.

Das Array **ztdkk()** wird nun so verschoben, das der Index (0) den Wert des Index (**max**) erhält, Index (1) den Wert von Index (**max+1**) und so weiter.

So werden die unrelevanten Daten des Messsystems entfernt dass nur noch Messdaten des Objektes vorliegen und ein direkter Zusammenhang zwischen den Arrays **ztdkk(), AmpKor()** und **Dist()** hergestellt werden kann.

Die Absolutwerte **abs{ztdkk()}** werden nun mit den Korrekturwerten von **AmpKor()** multipliziert und zusammen mit den Werten von **Dist()** grafisch dargestellt.

Auf der y-Achse ist nun die Einheit UNIT als Indikator der Reflexion und auf der x-Achse die Einheit METER als Indikator über die Entfernung zu finden.

Die Darstellung der y-Achse kann auch logarithmisch erfolgen, um eine bessere Auflösung von starken und schwachen Stoßstellen zu ermöglichen.

Bestimmung von Kabeldämpfungen

Wie unschwer zu erkennen ist, spielte bei der eigentlichen Fehlerortmessung die Center-Frequenz bisher keine Rolle. Die Messung soll, wie schon oben erwähnt jedoch in dem Frequenzbereich durchgeführt werden, indem das Objekt auch betrieben wird. Bei der korrekten Bestimmung der Kabeldämpfung, spielt die Center-Frequenz nun aber eine erhebliche Rolle, da diese vom benutzten Frequenzbereich stark abhängig ist.

In der Regel wird die Kabeldämpfung für 1 GHz angegeben und damit auch alle anderen Frequenzbereiche abgedeckt, was je nach Kabel jedoch zu erheblichen Messfehlern führt.

Aus diesem Grund soll an dieser Stelle ein Verfahren aufgezeigt werden, mit dem es möglich ist, die Kabeldämpfung für jede beliebige Frequenz innerhalb eines Bereiches zu ermitteln, ohne einen Referenzwert für genau diesen Punkt zu besitzen.

Dazu werden im Vorfeld folgende Überlegungen angestellt:

- Die Kabeldämpfung ist, aufgetragen in einer logarithmischen Teilung, einer e-Funktion ähnlich, eine Tatsache, die aus den Verlusten des Dielektrikum herrührt, welche sich über den Frequenzbereich nicht linear verhalten.
- Die Funktion kann innerhalb eines endlichen Frequenzbereichs mit einer Formel nachgebildet werden, die eine kubische Form hat.
- Die Stützstellen zur Bestimmung der Formel dürfen nicht den Anspruch genügen äquidistant zu sein.

Ausgehend von diesen Punkten liegt es nahe, den Bereich der numerischen Mathematik zu bemühen. Dort findet sich ein Verfahren, welches mittels vier Stützstellen eine Formel der Form

$$p(x) = a*x^3 + b*x^2 + c*x + d$$

erzeugen kann, die zudem die Bedingung erfüllt, die Werte der Stützstellen genau zu durchlaufen.

Dieses Verfahren nennt sich: Interpolation durch Polynome nach Newton

Das Verfahren eignet sich hervorragend um in der Rechnertechnik eingesetzt zu werden.

Auch wenn die Stützstellen nicht äquidistant seinen müssen, so ist es jedoch sehr zu empfehlen, den Frequenzbereich möglichst gleichmäßig zu unterteilen, um damit die Integrität der Formel zu erhöhen.

Zudem sollte die Formel nicht über die beiden Eckwerte hinaus angewendet werden, da in diesem Bereich die Formel schnell ungenau wird.

In der Praxis haben sich Stützstellen bei 170Mhz, 450Mhz, 900Mhz und 1800Mhz sehr bewährt, wobei die Formel dann im Bereich von 170Mhz bis 1800Mhz eingesetzt werden kann.

Nachfolgend soll eine rechnertechnische Variante aufgezeigt werden, die das Polynom wie beschrieben erzeugt.

**** Erzeugung des Polynoms****

anz=4                         *** Anzahl der Stützstellen

redim x1(anz)                 *** Frequenzwerte (in logarithmischer Form)
redim y1(anz)                 *** Koeffizienten des erzeugten Polynoms
redim y2(anz)                 *** Dämpfungswerte an den Stützstellen


x1(1)=log10(170/100)          *
x1(2)=log10(450/100)          ** Logarithmieren der Frequenzen
x1(3)=log10(900/100)          **
x1(4)=log10(1800/100)         *


y2(1)= Wert 1 bei 170Mhz      *
y2(2)= Wert 2 bei 450Mhz      ** Zuweisen der spezifischen Stützstellen
y2(3)= Wert 3 bei 900Mhz      ** zu den Frequenzen mit der Einheit dB/m
y2(4)= Wert 4 bei 1800Mhz     *


*** lauf und laufa sind lediglich Index-Variablen, die innerhalb
*** von Schleifen eingesetzt werden
*** Erzeugung des Koeffizienten ***


```
for lauf = 2 to anz
        for laufa = lauf to anz
                y2(laufa)=(y1(laufa)-y1(laufa-1))/(x1(laufa)-x1(laufa-lauf+1))
        next laufa
        for laufa = lauf to anz
                y1(laufa)=y2(laufa)
```

```
next laufa

next lauf

for lauf = 1 to anz-1

        for laufa = anz-1 to lauf step -1

                y1(laufa)=y1(laufa)+(y1(laufa+1)*-x1(laufa-lauf+1))

        next laufa

next lauf


****Benutzung des Polynoms****


input "Frequenz in Mhz (170Mhz - 1800Mhz) = ",f

xp=log10(f/100)

y=0

for lauf = anz to 1 step -1

        y=y+y1(lauf)*xp^(lauf-1)

next lauf

print " Die Dämpfung des Kabels beträgt bei ";f;"Mhz = ";y;"dB/m."
```

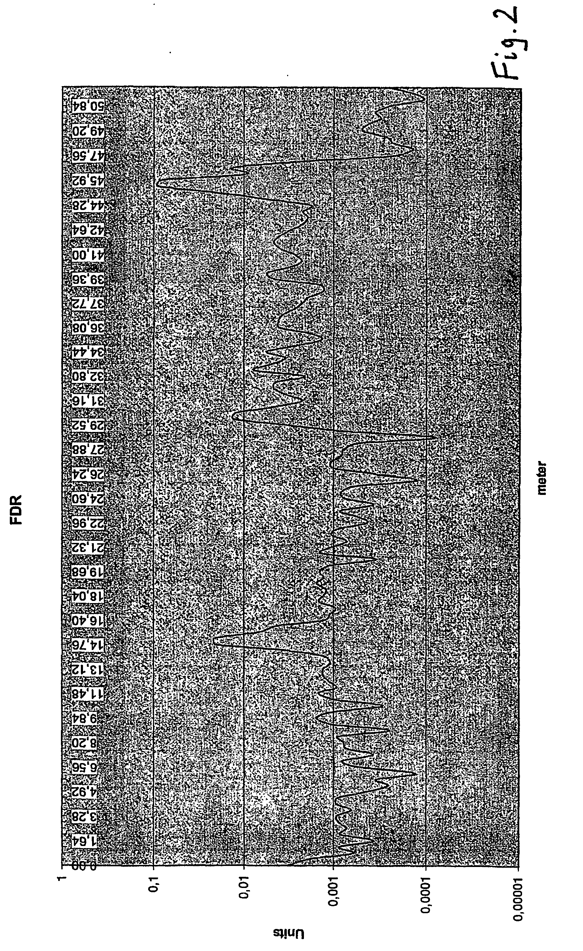

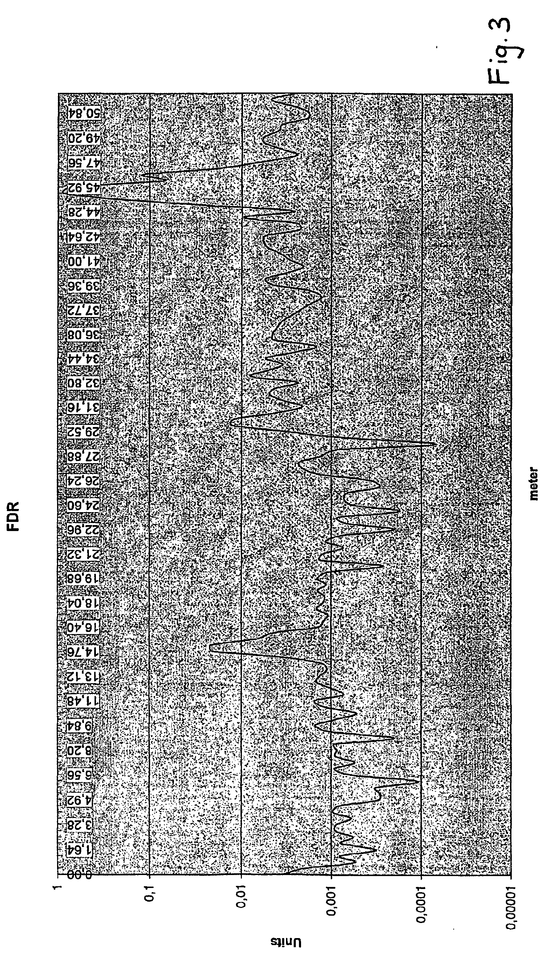

Das kleine Basic-Programm soll hier eine Möglichkeit zur Erzeugung des Polynoms darstellen, welche sich in der Praxis sehr bewährt hat.
Durch die vorangegangene Betrachtung ist es nun möglich, für jede Center-Frequenz die passende Kabeldämpfung zu errechnen (innerhalb der Stützstellen) und so ein Optimum bezüglich der Kabeldämpfungskorrektur zu erreichen.
Innerhalb des SPAN-Bereichs um die Center-Frequenz herum ist dieser Kabeldämpfungswert ebenfalls nur eine Näherung. Da man jedoch bei relativ kleinen Span-Bereichen von einem linearen Verlauf der Dämpfungsänderung ausgehen kann, bedeutet dies, dass die Rechnung mit dem Mittelwert einen relativ kleinen Fehler erzeugt.
Im Messdiagramm nach Figur 2 ist eine Leitung aus drei miteinander verbundenen Kabeln mit jeweils einer Länge von 15m zu erkennen, die mit einem Fehlabschluss mit einem Wert von s=1,2 abgeschlossen sind. Der Fehlabschluss ist bei Lauflänge 45m deutlich als starker Peak zu erkennen. Das letzte Kabel (Bereich von 30-45m) wurde in der Vergangenheit stark beansprucht und weist daher etwas schlechtere Anpassungswerte auf als die beiden ersten Kabel. Die Messung wurde bei 1200Mhz durchgeführt, was die relativ hohen Reflexionswerte der Übergänge zwischen den Kabeln bei den Lauflängen 15m und 30m erklärt. Die Messdynamik liegt hier bei etwa 55dB, ausreichend um Stoßstellen mit einer Anpassung von 40dB sicher erkennen zu können.
Die Messung gemäß Figur 3 zeigt die gleiche Anordnung von Kabeln und
Übergängen, wie das vorhergehende Diagramm in Figur 2. Als Unterschied ist lediglich der Abschluss am Ende des Kabels zu sehen, der hier einen Reflexionsfaktor von ca. 1 aufweist, d.h. ein offenes Ende ist. Dadurch ergibt sich ein sehr hoher Peak mit dem Wert 1 bei der Lauflänge von 45m. Es ist deutlich zu erkennen, daß die Messdynamik in vollem Umfang ausgenutzt werden kann, ohne qualitative Einbuße der Messwerte erkennen zu können.
Das oben beschriebene Verfahren zur Fehlerortbestimmung mit Spektrumanalysatoren besitzt den Vorteil einer hohen Messdynamik (besser 50dB) bei minimalen Kalibrieraufwand. Die Messergebnisse konnten in vielen Untersuchungen in ihrer Genauigkeit bestätigt werden. Der benötigte Rechenaufwand ist dabei überschaubar und von modernen Rechnersystemen problemlos zu bewältigen.


**Patentansprüche**

1.  Verfahren zur Fehlerortmessung bei Hochfrequenzkabeln und Leitungen, mit den Schritten:

a) Durchführen einer ersten Kalibriermessung mit einem SHORT am Ende des Messkabels (4), Abspeichern der Messwerte in einem Array as(), Unterziehen der Messwerte einer inversen Fouriertransformation und Abspeichern in einem Array zts(),

b) Durchführen einer zweiten Kalibriermessung mit einem LOAD am Ende des Messkabels (4), Abspeichern der Messwerte in einem Array zl(), Unterziehen der Messwerte einer Fouriertransformation und Abspeichern in einem Array ztl(),

c) Aussenden eines Signals mit der Frequenz f0 und einem Pegel a0 von einer Signalquelle (1),

d) Aufteilen des Signals in einem Powersplitter (3) und Weiterleitung des Signals zu gleichen Teilen in einen Prüfling (5) DUT und eine Senke (2),

e) Messen des Summensignals der Quelle (1) und der rücklaufenden Welle des DUT (5) mit der Frequenz f0 und einer Amplitude a1 an der Senke (2) und Abspeichern der zur Frequenz f0 zugeordneten Amplitude a1 in einem Array zd(),

f) Ändern der Frequenz f0 um einen vorgegebenen Frequenzbetrag dF und Wiederholen der Schritte a) - d) bis die Frequenz f0 eine vorgegebene Grenzfrequenz erreicht,

g) Anwenden einer inversen Fouriertransformation auf die Messwerte ad() und Abspeichern der Ergebnisse in einem Array ztd()

h) Normieren der Messwerte des Prüflings ztd() anhand der Messwerte zts() und ztl() aus der ersten und zweiten Kalibriermessung,

i) Bestimmen der Orte von Stoßstellen, unter Berücksichtigung des Verkürzungsfaktors.

2. Verfahren nach Anspruch 1, **dadurch gekennzeichnet, dass** die Messwerte ztd() mit einer Fensterfunktion window () multipliziert werden.

3. Verfahren nach Anspruch 2, **dadurch gekennzeichnet, dass** als Fensterfunktion window() ein Cosinus-Roll-Off Fenster verwendet wird.

4. Verfahren nach einem der vorhergehenden Ansprüche, **dadurch gekennzeichnet, dass** die Leitungsdämpfung und der Verkürzungsfaktor des Prüflings (5) in den Messwerten berücksichtigt wird.

5. Verfahren nach einem der vorhergehenden Ansprüche, **dadurch gekennzeichnet, dass** die Leitungsdämpfung des Prüflings (5) über den gemessenen Frequenzbereich durch Interpolation mittels einer kubischen Polynoms anhand von einigen wenigen Messpunkten bestimmt wird.

**Claims**

1. Process for measuring fault locations in high-frequency cables and lines, having the steps:

a) carrying out a first calibration measurement using a SHORT at the end of the measuring cable (4) storing the measured values in an array as(), subjecting the measured values to an inverse Fourier transformation and storing in an array zts(),

b) carrying out a second calibration measurement using a LOAD at the end of the measuring cable (4), storing the measured values in an array zl(), subjecting the measured values to a Fourier transformation and storing in an array ztl(),

c) emitting a signal at a frequency f0 and a level a0 from a signal source (1),

d) splitting the signal in a power splitter (3) and relaying the signal in equal parts to a test piece (5) DUT and a sink (2),

e) measuring the added signal of the source (1) and the returning wave of the DUT (5) at the frequency f0 and an amplitude a1 at the sink (2) and storing the amplitude a1 assigned to the frequency f0 in an array zd(),

f) changing the frequency f0 by a preset frequency amount dF and repeating steps a) - d) until the frequency f0 reaches a present limiting frequency,

g) applying an inverse Fourier transformation to the measured values ad() and storing the results in an array ztd()

h) standardising the measured values of the test piece ztd() using the measured values zts() and ztl() from the first and second calibration measurement,

i) determining the locations of impedance jumps taking into account the shortening factor.

2. Process according to claim 1, **characterised in that** the measured values ztd() are multiplied by a window function window().

3. Process according to claim 2, **characterised in that** a cosine roll-off window is used as the window function window ().

4. Process according to one of the preceding claims, **characterised in that** the line attenuation and the shortening factor of the test piece (5) is taken into account in the measured values.

5. Process according to one of the preceding claims, **characterised in that** the line attenuation of the test piece (5) is determined over the measured frequency range by interpolation by means of a cubic polynomial using a few measuring points.

**Revendications**

1. Procédé de localisation de défauts sur des câbles et lignes à haute fréquence, comportant les étapes suivantes :

   a) effectuer une première mesure de calibrage avec un SHORT à l'extrémité du câble de mesure (4), mémoriser les valeurs mesurées dans un tableau as ( ), soumettre les valeurs mesurées à une transformation de Fourier inverse et mémoriser dans un tableau zts ( ),
   b) effectuer une deuxième mesure de calibrage avec un LOAD à l'extrémité du câble de mesure (4), mémoriser les valeurs mesurées dans un tableau zl ( ), soumettre les valeurs mesurées à une transformation de Fourier et mémoriser dans un tableau ztl ( ),
   c) émettre un signal de fréquence f0 et de niveau a0 à partir d'une source de signal (1),
   d) diviser le signal dans un diviseur de puissance (3) et retransmettre le signal en parts identiques vers un élément à tester (5) DUT et vers un destinataire (2),
   e) mesurer le signal cumulé de la source (1) et l'onde revenant du DUT (5) de fréquence f0 et d'amplitude a1 au destinataire (2) et mémoriser l'amplitude a1 associée à la fréquence f0 dans un tableau zd ( ),
   f) modifier la fréquence f0 d'une valeur de fréquence prescrite dF et répéter les étapes a) à d) jusqu'à ce que la fréquence f0 atteigne une fréquence limite prédéterminée,
   g) appliquer une transformation de Fourier inverse aux valeurs mesurées ad ( ) et mémoriser les résultats dans un tableau ztd ( ),
   h) normaliser les valeurs mesurées de l'élément à tester ztd ( ) à l'aide des valeurs mesurées zts ( ) et ztl ( ) provenant de la première et de la deuxième mesure de calibrage,
   i) déterminer les emplacements de points de réflexion en tenant compte du facteur de réduction.

2. Procédé selon la revendication 1, **caractérisé par le fait que** l'on multiplie les valeurs mesurées ztd ( ) par une fonction de fenêtre window ( ).

3. Procédé selon la revendication 2, **caractérisé par le fait que** l'on utilise comme fonction de fenêtre window ( ) une fenêtre Cosinus-Roll-Off.

4. Procédé selon l'une des revendications précédentes, **caractérisé par le fait que** l'on prend en compte l'affaiblissement de ligne et le facteur de réduction de l'élément à tester (5) dans les valeurs mesurées.

5. Procédé selon l'une des revendications précédentes, **caractérisé par le fait que** l'on détermine l'affaiblissement de ligne de l'élément à tester (5) sur la plage fréquentielle mesurée à l'aide d'une interpolation par un polynôme cubique à l'aide de quelques points de mesure.

**Fig. 1**

Fig.2

Fig. 3